# EUROPÄISCHE PATENTSCHRIFT

(11) **EP 3 218 976 B1**
(45) Veröffentlichungstag und Bekanntmachung des Hinweises auf die Patenterteilung: **30.08.2023**
(21) Anmeldenummer: 15786886.0
(22) Anmeldetag: 16.10.2015
(51) Int. Cl.: H01P 1/202, H01P 1/20, H01R 24/42, H01R 24/54, H04B 5/00

(54) **HOCHFREQUENZVERBINDUNGSADAPTER MIT EINER DIELEKTRISCHEN KOPPELHÜLSE**
HIGH FREQUENCY CONNECTION ADAPTER WITH A DIELECTRIC COUPLING SLEEVE
ADAPTATEUR DE CONNEXION HAUTE FRÉQUENCE AVEC UN DOUILLE DE COUPLAGE DIÉLECTRIQUE

(30) Priorität: 14.11.2014 DE 102014116724
(43) Veröffentlichungstag der Anmeldung: 20.09.2017
(73) Patentinhaber: Phoenix Contact GmbH & Co. KG, 32825 Blomberg (DE)
(72) Erfinder: LILGE, Martin, 32805 Horn-Bad Meinberg (DE)
(74) Vertreter: Patentship Patentanwaltsgesellschaft mbH
(86) Internationale Anmeldenummer: PCT/EP2015/074000
(87) Internationale Veröffentlichungsnummer: WO 2016/074882

(56) Entgegenhaltungen:
- US-A- 2 743 422
- US-A- 5 969 684
- US-A- 5 969 684
- US-B2- 8 115 574

## Beschreibung

Die vorliegende Erfindung betrifft einen Hochfrequenzverbindungsadapter mit einer dielektrischen Koppelhülse.

Zwischen einer Antenne und einem Funkmodul wird häufig ein DC-Trennglied, wie ein DC-Block oder eine Antennenbarriere, angeordnet, um Gleichstromanteile aus einem zwischen der Antenne und dem Funkmodul übertragenen elektrischen Signal herauszufiltern. Als DC-Trennglied wird häufig ein aufwändig auf eine Leiterplatte aufgelöteter Kondensator in Form eines Surface Mount Device (SMD) Kondensators oder eines konventionell bedrahteten Kondensators verwendet. Sind die Antenne und das Funkmodul über eine Koaxialleitung verbunden, wird häufig ein koaxiales DC-Trennglied verwendet, bei dem der auf die Leiterplatte aufgelötete Kondensator über einen aufwändigen Lötprozess mit Innenleitern oder Außenleitern zweier Hochfrequenzverbinder des DC-Trenngliedes elektrisch leitend verbunden wird.

Die Druckschrift US 5,969,684 A offenbart eine Antenne mit einem metallischen Sockel und einer metallischen Hülse.

Die Druckschrift US 8,115,574 B2 offenbart eine dielektrische Koppelhülse.

Die Druckschrift US 2,743,422 offenbart einen Co-axialen Stumpf.

Es ist die der Erfindung zugrundeliegende Aufgabe, ein effizienteres Konzept zur kapazitiven Kopplung zweier elektrischer Leiter anzugeben.

Diese Aufgabe wird durch Gegenstände mit den Merkmalen nach dem unabhängigen Anspruch gelöst. Vorteilhafte Ausführungsformen der Erfindung sind Gegenstand der Figuren, der Beschreibung und der abhängigen Ansprüche.

Gemäß einem Aspekt der Erfindung wird die Aufgabe durch einen Hochfrequenzverbindungsadapter, mit einer dielektrische Koppelhülse für die kapazitive Kopplung eines ersten elektrischen Leiters mit einem zweiten elektrischen Leiter, wobei der zweite elektrische Leiter einen Leiterhohlraum aufweist, gelöst, mit: einem ersten Hülsenabschnitt mit einem ersten Durchmesser, wobei in dem ersten Hülsenabschnitt ein einseitig abgeschlossener Aufnahmeraum gebildet ist, in den der erste elektrische Leiter einsteckbar ist; und einem zweiten Hülsenabschnitt mit einem zweiten Durchmesser, wobei der zweite Durchmesser geringer als der erste Durchmesser ist, und wobei der zweite Hülsenabschnitt in den Leiterhohlraum einsteckbar ist. Dadurch wird der Vorteil erreicht, dass der erste elektrische Leiter und der zweite elektrische Leiter durch Entfallen eines aufwändigen Lötprozesses besonders kostengünstig kapazitiv gekoppelt werden können.

Die dielektrische Koppelhülse kann aus einem dielektrischen Material, wie Polytetrafluorethylen (PTFE), Polyethylen (PE), Polyamid (PA) oder Keramik, gebildet sein. Beispielsweise ist die dielektrische Koppelhülse ein mittels einer Drehbank gefertigtes Drehteil oder ein mittels einer Fräse gefertigtes Frästeil aus Teflon oder ein Teflonisolator. Der jeweilige Hülsenabschnitt und/oder der einseitig abgeschlossene Aufnahmeraum können ferner eine Zylinderform, insbesondere eine Kreiszylinderform, aufweisen. Beispielsweise beträgt der erste Durchmesser 1mm, 5mm, 10mm, 15mm oder 20mm, der zweite Durchmesser 0,5mm, 1mm, 3mm, 5mm, 8mm, 10mm oder 15mm und der Durchmesser des einseitig abgeschlossenen Aufnahmeraums 0,5mm, 1mm, 3mm, 5mm, 8mm, 10mm oder 15mm. Ferner kann eine Länge des jeweiligen Hülsenabschnittes 5mm, 10mm, 15mm, 20mm 25mm, 30mm oder 40mm betragen.

Die jeweiligen elektrischen Leiter können jeweils ein Innenleiter eines jeweiligen Hochfrequenzverbinders, wie einer N-Buchse oder eines SMA-Steckers, sein. Ferner können die jeweiligen elektrischen Leiter und die dielektrische Koppelhülse miteinander verpresst oder verklebt werden.

Gemäß dem Aspekt der Erfindung des Hochfrequenzverbindungsadapters erstreckt sich der einseitig abgeschlossene Aufnahmeraum zumindest teilweise in den zweiten Hülsenabschnitt. Dadurch wird der Vorteil erreicht, dass eine Kapazität eines durch die jeweiligen elektrischen Leiter und die dielektrische Koppelhülse gebildeten Kondensators erhöht werden kann.

In einer weiteren vorteilhaften Ausführungsform des Hochfrequenzverbindungsadapters ist ein Ende des zweiten Hülsenabschnitts dielektrisch geschlossen. Dadurch wird der Vorteil erreicht, dass eine galvanische Trennung der jeweiligen elektrischen Leiter erreicht werden kann.

In einer weiteren vorteilhaften Ausführungsform des Hochfrequenzverbindungsadapters ist ein Ende des zweiten Hülsenabschnitts kegelstumpfförmig, kegelförmig oder kuppelförmig gebildet. Dadurch wird der Vorteil erreicht, dass eine effiziente Einführhilfe zu Einführen der dielektrischen Koppelhülse in den Leiterhohlraum des zweiten elektrischen Leiters bereitgestellt werden kann. Beispielsweise ist das Ende des zweiten Hülsenabschnitts kegelstumpfförmig oder kegelförmig gebildet und der Öffnungswinkel des Endes des zweiten Hülsenabschnitts beträgt 35°, 40°, 45°, 50°, 55°, 59°, 60°, 65°, 70°, 75°, 80° oder 85°.

In einer weiteren vorteilhaften Ausführungsform des Hochfrequenzverbindungsadapters ist der erste elektrische Leiter in dem einseitig abgeschlossenen Aufnahmeraum durch Reibschluss halterbar ist, und ist der zweite Hülsenabschnitt in dem Leiterhohlraum durch Reibschluss halterbar. Dadurch wird der Vorteil erreicht, dass die dielektrische Koppelhülse effizient mit den jeweiligen elektrischen Leitern verbunden werden kann.

In einer weiteren vorteilhaften Ausführungsform des Hochfrequenzverbindungsadapters ist die dielektrische Koppelhülse einstückig gebildet. Dadurch wird der Vorteil erreicht, dass die dielektrische Koppelhülse besonders effizient hergestellt werden kann.

In einer weiteren vorteilhaften Ausführungsform des Hochfrequenzverbindungsadapters ist die dielektrische Koppelhülse aus Polytetrafluorethylen, Polyethylen, Polyamid oder Keramik gebildet. Dadurch wird der Vorteil erreicht, dass eine Dämpfung eines über die dielektrische Koppelhülse übertragenen Hochfrequenzsignals, wie eines Nutzsignals, gering sein kann. Beispielsweise ist die Keramik Steatit oder Aluminiumoxid.

In einer weiteren vorteilhaften Ausführungsform des Hochfrequenzverbindungsadapters weist die dielektrische Hülse an einem Übergang zwischen dem ersten Hülsenabschnitt und dem zweiten Hülsenabschnitt einen Durchmessersprung auf. Dadurch wird der Vorteil erreicht, dass eine Tiefe einer Einführung der dielektrischen Koppelhülse in den Leiterhohlraum des zweiten elektrischen Leiters effizient begrenzt werden kann, wenn der Leiterhohlraum des zweiten elektrischen Leiters einen geringeren Durchmesser als den ersten Durchmesser aufweist.

Gemäß dem Aspekt der Erfindung wird die Aufgabe durch den Hochfrequenzverbindungsadapter gelöst, mit: der dielektrischen Koppelhülse; einem ersten Hochfrequenzverbinder mit einem Gehäuse und einem ersten Innenleiter, welcher in einem Aufnahmeabschnitt des Gehäuses angeordnet ist, wobei der erste Innenleiter in den einseitig abgeschlossenen Aufnahmeraum des ersten Hülsenabschnitts eingesteckt ist und wobei der erste Hülsenabschnitt den Aufnahmeabschnitt zumindest abschnittsweise ausfüllt; einem zweiten Hochfrequenzverbinder mit einem zweiten Innenleiter, wobei der zweite Innenleiter einen Leiterhohlraum aufweist, in welchen der zweite Hülsenabschnitt eingesteckt ist. Dadurch wird der Vorteil erreicht, dass die jeweiligen Innenleiter effizient kapazitiv gekoppelt werden können.

Der Hochfrequenzverbindungsadapter kann ein koaxiales DC-Trennglied, wie ein koaxialer DC-Block oder eine Antennenbarriere, sein. Ferner kann der Hochfrequenzadapter den Anforderungen für eine Verwendung in einer der EX-Zonen 0, 1, oder 2 nach der Betriebssicherheitsverordnung (BetrSichV) oder der Leitlinie Atmosphäre Explosible (ATEX) genügen.

Der jeweilige Hochfrequenzverbinder kann ein Stecker oder eine Buchse nach einem der Standards N, DIN 7/16, SMA, RP-SMA, TNC, F, UHF, TNC oder BNC sein. Ferner können der jeweilige Innenleiter und/oder das Gehäuse aus Messing gefertigt und/oder vergoldet sein. Beispielsweise sind die jeweiligen Innenleiter mittels einer Drehbank gefertigte Drehteile oder mittels einer Fräse gefertigte Frästeile aus Messing. Die jeweiligen Innenleiter, das Gehäuse und/oder die dielektrische Koppelhülse können ferner miteinander verpresst oder verklebt sein. Ferner kann der Leiterhohlraum des zweiten Innenleiters einen Durchmesser von 0,5mm, 1mm, 4mm, 5mm, 8mm, 10mm oder 15mm aufweisen.

In einer vorteilhaften Ausführungsform des Hochfrequenzverbindungsadapters ist ein Ende des Leiterhohlraums des zweiten Innenleiters kegelstumpfförmig, kegelförmig oder kuppelförmig gebildet. Dadurch wird der Vorteil erreicht, dass, wenn ein Ende des zweiten Hülsenabschnitts der dielektrischen Koppelhülse kegelstumpfförmig, kegelförmig oder kuppelförmig gebildet ist, die dielektrische Koppelhülse den Leiterhohlraum des zweiten Innenleiters vollständig ausfüllen kann. Beispielsweise ist das Ende des Leiterhohlraums kegelstumpfförmig oder kegelförmig gebildet und der Öffnungswinkel des Endes des Leiterhohlraums beträgt 35°, 40°, 45°, 50°, 55°, 59°, 60°, 65°, 70°, 75°, 80° oder 85°.

In einer weiteren vorteilhaften Ausführungsform des Hochfrequenzverbindungsadapters weist der zweite Innenleiter einen ersten Innenleiterabschnitt, in welchem der Leiterhohlraum gebildet ist, mit einem dritten Durchmesser und einen zweiten Innenleiterabschnitt mit einem vierten Durchmesser auf, wobei der vierte Durchmesser geringer als der dritte Durchmesser ist. Dadurch wird der Vorteil erreicht, dass die zur Herstellung des zweiten Innenleiters benötigte Materialmenge reduziert werden kann. Beispielsweise beträgt der dritte Durchmesser 1mm, 2mm, 3mm, 4mm, 5mm, 6mm, 7mm, 8mm, 9mm, 10mm oder 15mm und beträgt der vierte Durchmesser 0,5mm, 1mm, 2mm, 3mm, 4mm, 5mm, 6mm, 7mm, 8mm, 9mm, 10mm oder 14mm.

In einer weiteren vorteilhaften Ausführungsform des Hochfrequenzverbindungsadapters weist der zweite Innenleiter an einem Übergang zwischen dem ersten Innenleiterabschnitt und dem zweiten Innenleiterabschnitt einen Durchmessersprung auf. Dadurch wird der Vorteil erreicht, dass der zweite Innenleiter besonders kostengünstig hergestellt werden kann.

Erfindungsgemäß ist der Hochfrequenzverbindungsadapter ausgebildet mit einem Adaptergehäuse, wobei an dem Adaptergehäuse ein Isolationselement angeordnet ist. Dadurch wird der Vorteil erreicht, dass der Hochfrequenzverbindungsadapter als eine Schaltschrankdurchführung für eine Koaxialleitung verwendet werden kann. Beispielsweise ist das Isolationselement durch einen Gummidichtring gebildet und wird das Isolationselement zur Abdichtung der Schaltschrankdurchführung gegen Feuchtigkeit und/oder Gase verwendet.

In einer weiteren vorteilhaften Ausführungsform des Hochfrequenzverbindungsadapters weist das Adaptergehäuse, einen elektrisch leitenden Anteil auf, wobei das Gehäuse des ersten Hochfrequenzverbinders und das weitere Gehäuse des zweiten Hochfrequenzverbinders über den elektrisch leitenden Anteil des Adaptergehäuses elektrisch leitend verbunden sind. Dadurch wird der Vorteil erreicht, dass ein Hochfrequenzsignal effizient von dem ersten Hochfrequenzverbinder zu dem zweiten Hochfrequenzverbinder übertragen werden kann. Gemäß einer Ausführungsform kann das Adaptergehäuse vollständig aus einem elektrisch leitenden Material, wie Messing, gebildet sein.

In einer weiteren vorteilhaften Ausführungsform des Hochfrequenzverbindungsadapters weist das Adaptergehäuse ferner einen Anschluss zum Anschließen einer Masseleitung auf. Dadurch wird der Vorteil erreicht, dass die Außenleiter der jeweiligen Hochfrequenzverbinder geerdet werden können. Beispielsweise ist der Anschluss zum Anschließen der Masseleitung durch ein Schraubengewinde in dem elektrisch leitenden Anteil des Adaptergehäuses und durch eine in das Schraubengewinde einschraubbare Schraube gebildet.

In einer weiteren vorteilhaften Ausführungsform des Hochfrequenzverbindungsadapters ist das Gehäuse des ersten Hochfrequenzverbinders und/oder das weitere Gehäuse des zweiten Hochfrequenzverbinders mit dem Adaptergehäuse verpressbar. Dadurch wird der Vorteil erreicht, dass der erste Hochfrequenzverbinder und/oder der zweite Hochfrequenzverbinder besonders kostengünstig mit dem Adaptergehäuse verbunden werden können. Beispielsweise ist der zweite Hochfrequenzverbinder eine Einpressbuchse.

Ausführungsbeispiele der Erfindung sind in den Zeichnungen dargestellt und werden im Folgenden näher beschrieben.

Es zeigen:
- Fig. 1: eine schematische Querschnittsansicht einer dielektrischen Koppelhülse gemäß einer Ausführungsform;
- Fig. 2: eine schematische Querschnittsansicht eines Hochfrequenzverbindungsadapters gemäß einer Ausführungsform;
- Fig. 3: eine schematische Querschnittsansicht des ersten Innenleiters;
- Fig. 4: eine schematische Querschnittsansicht des zweiten Innenleiters; und
- Fig. 5: einen schematischen Ersatzschaltplan des Hochfrequenzverbindungsadapters.

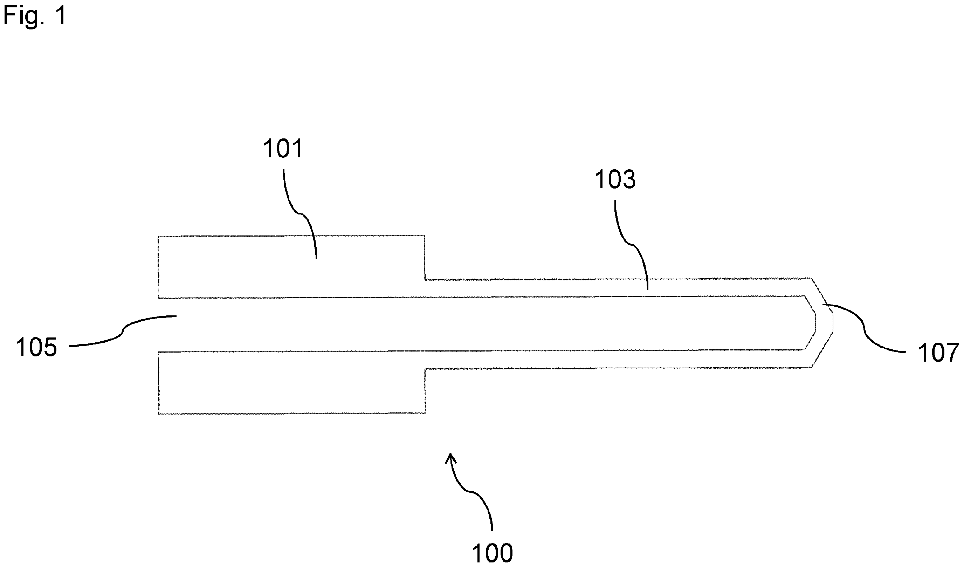

Fig. 1 zeigt eine schematische Querschnittsansicht einer dielektrischen Koppelhülse 100 gemäß einer Ausführungsform. Die dielektrische Koppelhülse 100 weist einen ersten Hülsenabschnitt 101, einen zweiten Hülsenabschnitt 103, einen Aufnahmeraum 105 und ein Ende 107 auf. Der Aufnahmeraum 105 erstreckt sich von dem ersten Hülsenabschnitt 101 in den zweiten Hülsenabschnitt 103. Ferner weist das Ende 107 des zweiten Hülsenabschnitts 103 eine Kegelstumpfform auf. Beispielsweise beträgt eine Länge des ersten Hülsenabschnittes 101 15mm, eine Länge des zweiten Hülsenabschnittes 103 23mm, eine Länge des Endes 107 1,6mm und der Öffnungswinkel des Endes 107 59°.

Die dielektrische Koppelhülse 100 für die kapazitive Kopplung eines ersten elektrischen Leiters mit einem zweiten elektrischen Leiter, wobei der zweite elektrische Leiter einen Leiterhohlraum aufweist, kann ausgebildet sein mit: dem ersten Hülsenabschnitt 101 mit einem ersten Durchmesser, wobei in dem ersten Hülsenabschnitt 101 der einseitig abgeschlossener Aufnahmeraum 105 gebildet ist, in den der erste elektrische Leiter einsteckbar ist; und dem zweiten Hülsenabschnitt 103 mit einem zweiten Durchmesser, wobei der zweite Durchmesser geringer als der erste Durchmesser ist, und wobei der zweite Hülsenabschnitt 103 in den Leiterhohlraum einsteckbar ist.

Die dielektrische Koppelhülse 100 kann aus einem dielektrischen Material, wie Polytetrafluorethylen (PTFE), Polyethylen (PE), Polyamid (PA) oder Keramik, gebildet sein. Beispielsweise ist die dielektrische Koppelhülse 100 ein mittels einer Drehbank gefertigtes Drehteil oder ein mittels einer Fräse gefertigtes Frästeil aus Teflon oder ein Teflonisolator. Der jeweilige Hülsenabschnitt 101, 103 und/oder der einseitig abgeschlossene Aufnahmeraum 105 können ferner eine Zylinderform, insbesondere eine Kreiszylinderform, aufweisen. Beispielsweise beträgt der erste Durchmesser 1mm, 5mm, 10mm, 15mm oder 20mm, der zweite Durchmesser 0,5mm, 1mm, 3mm, 5mm, 8mm, 10mm oder 15mm und der Durchmesser des einseitig abgeschlossenen Aufnahmeraums 105 0,5mm, 1mm, 3mm, 5mm, 8mm, 10mm oder 15mm. Ferner kann eine Länge des jeweiligen Hülsenabschnittes 101, 103 5mm, 10mm, 15mm, 20mm 25mm, 30mm oder 40mm betragen.

Die jeweiligen elektrischen Leiter können jeweils ein Innenleiter eines jeweiligen Hochfrequenzverbinders, wie einer N-Buchse oder eines SMA-Steckers, sein. Ferner können die jeweiligen elektrischen Leiter und die dielektrische Koppelhülse 101 miteinander verpresst oder verklebt werden.

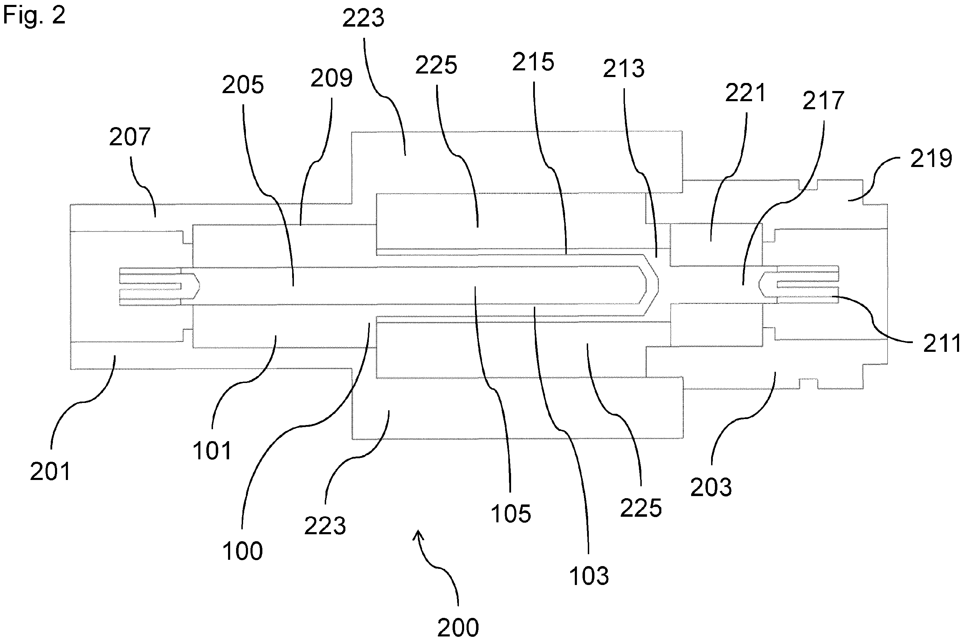

Fig. 2 zeigt eine schematische Querschnittsansicht eines Hochfrequenzverbindungsadapters 200 gemäß einer Ausführungsform. Der Hochfrequenzverbindungsadapter 200 umfasst die dielektrische Koppelhülse 100, einen ersten Hochfrequenzverbinder 201 und einen zweiten Hochfrequenzverbinder 203. Die jeweiligen Hochfrequenzverbinder 201, 203 sind durch N-Buchsen gebildet. Der erste Hochfrequenzverbinder 201 umfasst einen ersten Innenleiter 205 und ein Gehäuse 207 mit einem Aufnahmeabschnitt 209. Hierbei ist der erste Hülsenabschnitt 101 der dielektrischen Koppelhülse 100 in dem Aufnahmeabschnitt 209 aufgenommen. Ferner ist der erste Innenleiter 205 teilweise in den einseitig abgeschlossen Aufnahmeraum 105 eingesteckt. Der zweite Hochfrequenzverbinder 203 umfasst einen zweiten Innenleiter 211, welcher einen ersten Innenleiterabschnitt 213 mit einem Leiterhohlraum 215 und einen zweiten Innenleiterabschnitt 217 aufweist, ein weiteres Gehäuse 219 und ein Isolationselement 221, welches den zweiten Innenleiterabschnitt 217 und das weitere Gehäuse 219 galvanisch trennt. Ferner ist der zweite Hülsenabschnitt 103 der dielektrischen Koppelhülse 100 in den Leiterhohlraum 215 eingesteckt. Der Hochfrequenzverbindungsadapter 200 umfasst ferner ein Adaptergehäuse 223 und einen Leerraum 225. Ferner ist das weitere Gehäuse 219 in das Adaptergehäuse 223 eingepresst.

Beispielsweise beträgt eine Länge des ersten Innenleiters 205 43mm, eine Länge des ersten Innenleiterabschnitts 213 24mm, eine Länge des Leiterhohlraums 215 23mm, eine Länge des zweiten Innenleiterabschnitts 217 13,7mm, ein Durchmesser des ersten Innleiterabschnitts 213 6mm, ein Durchmesser des Leiterhohlraums 215 5mm und ein Durchmesser des zweiten Innenleiterabschnitts 217 3mm. Ferner kann das Isolationselement 221 aus einem dielektrischen Material, wie Polytetrafluorethylen (PTFE), Polyethylen (PE), Polyamid (PA) oder Keramik, gebildet sein.

Der Hochfrequenzverbindungsadapter 200 kann ausgebildet sein mit: der dielektrischen Koppelhülse 100; dem ersten Hochfrequenzverbinder 201 mit dem Gehäuse 207 und dem ersten Innenleiter 205, welcher in dem Aufnahmeabschnitt 209 des Gehäuses 207 angeordnet ist, wobei der erste Innenleiter 205 in den einseitig abgeschlossenen Aufnahmeraum 105 des ersten Hülsenabschnitts 101 eingesteckt ist und wobei der erste Hülsenabschnitt 101 den Aufnahmeabschnitt 209 zumindest abschnittsweise ausfüllt; dem zweiten Hochfrequenzverbinder 203 mit dem zweiten Innenleiter 211, wobei der zweite Innenleiter 211 einen Leiterhohlraum 215 aufweist, in welchen der zweite Hülsenabschnitt 103 eingesteckt ist.

Der Hochfrequenzverbindungsadapter 200 kann ein koaxiales DC-Trennglied, wie ein koaxialer DC-Block oder eine Antennenbarriere, sein. Ferner kann der Hochfrequenzadapter 200 den Anforderungen für eine Verwendung in einer der EX-Zonen 0, 1, oder 2 nach der Betriebssicherheitsverordnung (BetrSichV) oder der Leitlinie Atmosphäre Explosible (ATEX) genügen.

Der jeweilige Hochfrequenzverbinder 200 kann ein Stecker oder eine Buchse nach einem der Standards N, DIN 7/16, SMA, RP-SMA, TNC, F, UHF, TNC oder BNC sein. Ferner können der jeweilige Innenleiter 205, 211 und/oder das Gehäuse 207 aus Messing gefertigt und/oder vergoldet sein. Beispielsweise sind die jeweiligen Innenleiter 205, 211 mittels einer Drehbank gefertigte Drehteile oder mittels einer Fräse gefertigte Frästeile aus Messing. Die jeweiligen Innenleiter 205, 211, das Gehäuse 207 und/oder die dielektrische Koppelhülse 100 können ferner miteinander verpresst oder verklebt sein. Ferner kann der Leiterhohlraum 215 des zweiten Innenleiters 211 einen Durchmesser von 0,5mm, 1mm, 4mm, 5mm, 8mm, 10mm oder 15mm aufweisen.

Gemäß einer Ausführungsform kann der Hochfrequenzverbindungsadapter 200 durch Zusammenstecken und Verpressen einfach und schnell gefertigt werden.

Gemäß einer weiteren Ausführungsform kann ein Verguss des Leerraums 225, beispielsweise mit einem Dielektrikum, entfallen.

Gemäß einer weiteren Ausführungsform kann der Hochfrequenzverbindungsadapter 200 als eine Schaltschrankdurchführung im Außenbereich verwendet werden. Hierbei kann an dem Hochfrequenzverbindungsadapter 200 ein Gummidichtring angeordnet werden, um die Anforderungen der Schutzart IP54 zu erfüllen.

Gemäß einer weiteren Ausführungsform kann der Hochfrequenzverbindungsadapter 200 zum Übertragen von Hochfrequenzsignalen im Frequenzbereich 700MHz bis 6GHz bei einer Leistung von 1W ausgebildet sein. Ferner kann der Hochfrequenzverbindungsadapter 200 einen Isolationsspannungsfestigkeitswert von 375Us oder 265V Wechselspannung aufweisen, um der Norm DIN EN 60079-11:2012 zu genügen. Ferner kann eine Dämpfung eines über den Hochfrequenzverbindungsadapters 200 übertragenen Hochfrequenzsignals weniger als 0,6dB bei 868MHz und/oder weniger als 0,5dB bei 2,4GHz betragen. Ferner kann der Hochfrequenzverbindungsadapter 200 eine Impedanz von 50Ω aufweisen und in einem Temperaturbereich von -40°C bis 85°C oder in einem Temperaturbereich von -40°C bis 75°C einsetzbar sein.

Gemäß einer weiteren Ausführungsform kann der Leerraum 225 eine Höhe von zumindest 6mm oder von zumindest 10mm aufweisen. Ferner kann die dielektrische Koppelhülse 100 eine Materialstärke von zumindest 1mm und einen Kriechstromfestigkeitswert von 175CTI aufweisen.

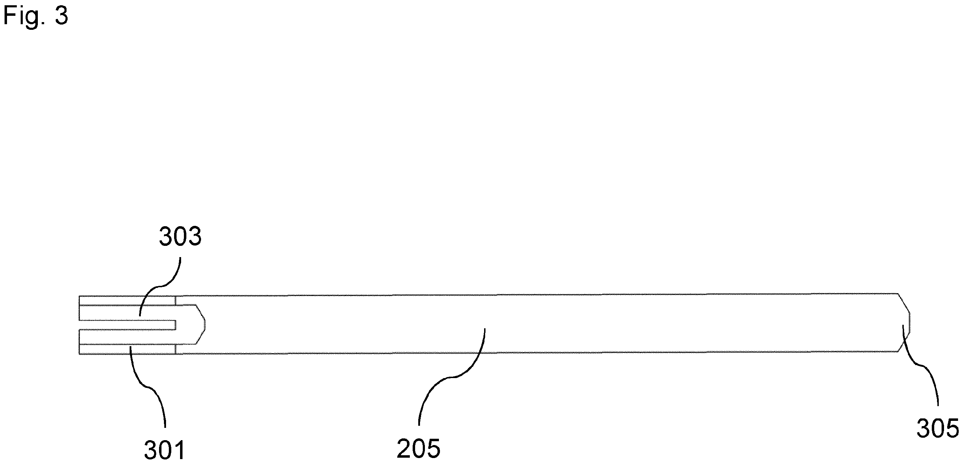

Fig. 3 zeigt eine schematische Querschnittsansicht des ersten Innenleiters 205. Der erste Innenleiter 205 weist ein Kontaktende 301 mit einer Ausnehmung 303 und ein kegelstumpfförmiges Einführende 305 auf. Mittels des Kontaktendes 301 kann ein Innenleiter eines mit dem ersten Hochfrequenzverbinder 201 verbundenen weiteren Hochfrequenzverbinders kontaktiert werden. Hierzu kann der Innenleiter des weiteren Hochfrequenzverbinders in die Ausnehmung 303 eingeführt werden, um einen elektrischen Kontakt mit dem ersten Innenleiter 205 herzustellen. Ferner kann das kegelstumpfförmige Einführende 305 in den Aufnahmeraum 105 der dielektrischen Koppelhülse 100 eingeführt werden.

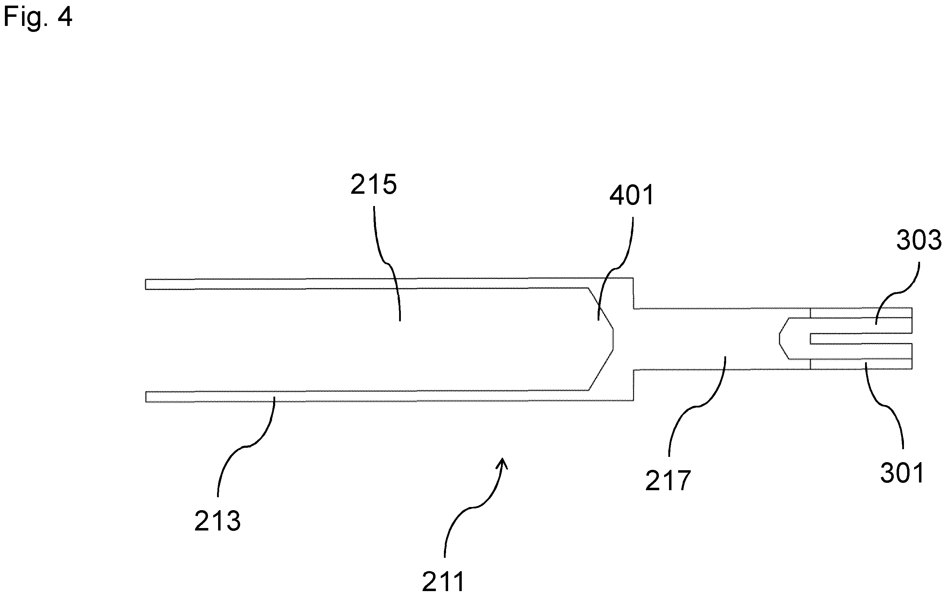

Fig. 4 zeigt eine schematische Querschnittsansicht des zweiten Innenleiters 211. Der zweite Innenleiter 211 umfasst den ersten Innenleiterabschnitt 213, den Leiterhohlraum 215 mit einem kegelstumpfförmigen Ende 401, den zweiten Innenleiterabschnitt 217 und ein Kontaktende 301 mit einer Ausnehmung 303. Beispielsweise beträgt der Öffnungswinkel des kegelstumpfförmigen Endes 401 59°.

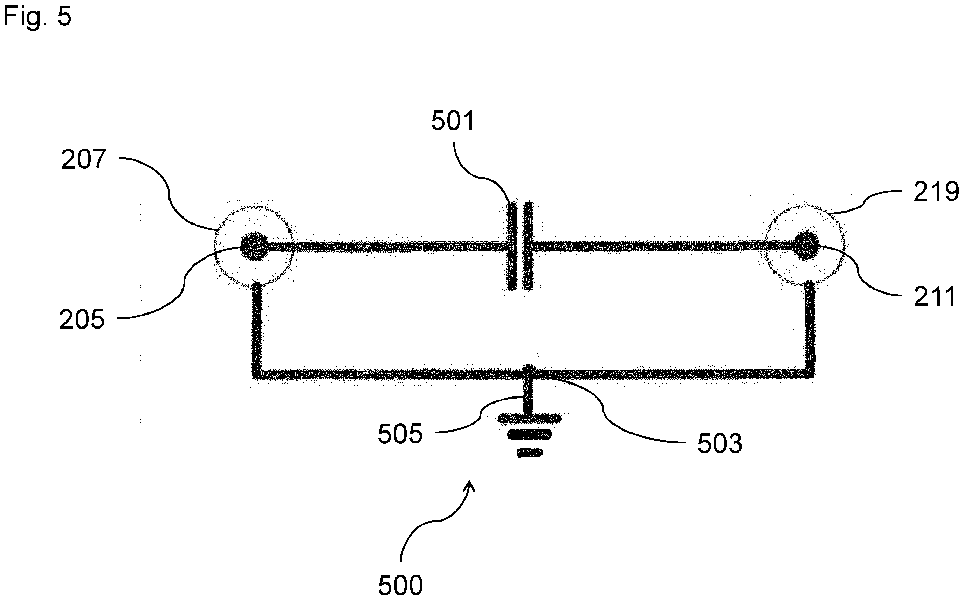

Fig. 5 zeigt einen schematischen Ersatzschaltplan 500 des Hochfrequenzverbindungsadapters 200. In dem Ersatzschaltplan 500 sind der erste Innenleiter 205, das Gehäuse 207, der zweite Innenleiter 211, das weitere Gehäuse 219, ein Kondensator 501 und ein Anschluss 503, an welchem eine Masseleitung 505 angeschlossen ist, abgebildet. Die jeweiligen Innenleiter 205, 211 sind über den Kondensator 501 kapazitiv gekoppelt. Ferner sind das Gehäuse 207 und das weitere Gehäuse 219 über die Masseleitung 505 geerdet. Der Kondensator 501 ist hierbei durch die Anordnung der dielektrischen Koppelhülse 100 mit den jeweiligen Innenleitern 205, 211 gebildet. Beispielsweise beträgt die Kapazität des Kondensators 510 1pF, 5pF, 10pF, 15pF, 20pF 25pF, 30pF, 35pF, 40pF, 45pF oder 50pF.

Gemäß einer weiteren Ausführungsform kann der Hochfrequenzverbindungsadapter 200 ohne Lötprozess und/oder ohne Verwendung eines Leiterplattendesigns gefertigt werden.

Gemäß einer weiteren Ausführungsform kann mittels des Hochfrequenzverbindungsadapters 200, wie einer Antennenbarriere, ein Hochfrequenzausgang eines Funkmoduls eigensicher ausgeführt werden.

Gemäß einer weiteren Ausführungsform kann der Hochfrequenzverbindungsadapter 200 den Anforderungen nach den Standards ATEX-Produktrichtlinie 94/9/EG, DIN EN 60079-11, ATEX/IECEx II 2 (1) G Ex [ia] IIC Ga und/oder ATEX/IECEx II 2 (1) G Ex nA [iaGa] IIC T6 Gc genügen.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren. Die Erfindung ist durch die folgenden Ansprüche definiert.

### BEZUGSZEICHENLISTE

- 100: Dielektrische Koppelhülse
- 101: Erster Hülsenabschnitt
- 103: Zweiter Hülsenabschnitt
- 105: Aufnahmeraum
- 107: Ende

- 200: Hochfrequenzverbindungsadapter
- 201: Erster Hochfrequenzverbinder
- 203: Zweiter Hochfrequenzverbinder
- 205: Erster Innenleiter
- 207: Gehäuse
- 209: Aufnahmeabschnitt
- 211: Zweiter Innenleiter
- 213: Erster Innenleiterabschnitt
- 215: Leiterhohlraum
- 217: Zweiter Innenleiterabschnitt
- 219: Weiteres Gehäuse
- 221: Isolationselement
- 223: Adaptergehäuse
- 225: Leerraum

- 301: Kontaktende
- 303: Ausnehmung
- 305: Einführende

- 401: Ende

- 500: Ersatzschaltplan
- 501: Kondensator
- 503: Anschluss
- 505: Masseleitung

## Patentansprüche

1. Hochfrequenzverbindungsadapter (200), mit einer dielektrischen Koppelhülse (100) für die kapazitive Kopplung eines ersten elektrischen Leiters mit einem zweiten elektrischen Leiter, wobei der zweite elektrische Leiter einen Leiterhohlraum (215) aufweist, mit:
einem ersten Hülsenabschnitt (101) mit einem ersten Durchmesser, wobei in dem ersten Hülsenabschnitt (101) ein einseitig abgeschlossener Aufnahmeraum (105) gebildet ist, in den der erste elektrische Leiter einsteckbar ist; und
einem zweiten Hülsenabschnitt (103) mit einem zweiten Durchmesser, wobei der zweite Durchmesser geringer als der erste Durchmesser ist, und wobei der zweite Hülsenabschnitt (103) in den Leiterhohlraum (215) einsteckbar ist, wobei sich der einseitig abgeschlossene Aufnahmeraum (105) zumindest teilweise in den zweiten Hülsenabschnitt (103) erstreckt,
einem ersten Hochfrequenzverbinder (201) mit einem Gehäuse (207) und einem ersten Innenleiter (205), welcher in einem Aufnahmeabschnitt (209) des Gehäuses (207) angeordnet ist, wobei der erste Innenleiter (205) in den einseitig abgeschlossenen Aufnahmeraum (105) des ersten Hülsenabschnitts (101) eingesteckt ist und wobei der erste Hülsenabschnitt (101) den Aufnahmeabschnitt (209) zumindest abschnittsweise ausfüllt;
einem zweiten Hochfrequenzverbinder (203) mit einem zweiten Innenleiter (211), wobei der zweite Innenleiter (211) einen Leiterhohlraum (215) aufweist, in welchen der zweite Hülsenabschnitt (103) eingesteckt ist,
wobei der zweite Innenleiter (211) einen ersten Innenleiterabschnitt (213) mit dem Leiterhohlraum (215) und einen zweiten Innenleiterabschnitt (217) aufweist, sowie ein weiteres Gehäuse (219) und ein Isolationselement (221) aufweist, welches den zweiten Innenleiterabschnitt (217) und das weitere Gehäuse (219) galvanisch trennt, wobei der zweite Hülsenabschnitt (103) der dielektrischen Koppelhülse (100) in den Leiterhohlraum (215) eingesteckt ist, wobei der Hochfrequenzverbindungsadapter (200) ferner ein Adaptergehäuse (223) und einen Leerraum (225) umfasst, wobei das weitere Gehäuse (219) in das Adaptergehäuse (223) eingepresst ist.

2. Hochfrequenzverbindungsadapter (200) nach Anspruch 1, wobei ein Ende (107) des zweiten Hülsenabschnitts (105) dielektrisch geschlossen ist.

3. Hochfrequenzverbindungsadapter (200) nach einem der vorangehenden Ansprüche, wobei ein Ende (107) des zweiten Hülsenabschnitts (103) kegelstumpfförmig, kegelförmig oder kuppelförmig gebildet ist.

4. Hochfrequenzverbindungsadapter (200) nach einem der vorangehenden Ansprüche, wobei der erste elektrische Leiter in dem einseitig abgeschlossenen Aufnahmeraum (105) durch Reibschluss halterbar ist, und wobei der zweite Hülsenabschnitt (103) in dem Leiterhohlraum (215) durch Reibschluss halterbar ist.

5. Hochfrequenzverbindungsadapter (200) nach einem der vorangehenden Ansprüche, wobei die dielektrische Koppelhülse (100) einstückig gebildet ist.

6. Hochfrequenzverbindungsadapter (200) nach einem der vorangehenden Ansprüche, wobei die dielektrische Koppelhülse (100) aus Polytetrafluorethylen, Polyethylen, Polyamid oder Keramik gebildet ist.

7. Hochfrequenzverbindungsadapter (200) nach einem der vorangehenden Ansprüche, wobei die dielektrische Hülse (100) an einem Übergang zwischen dem ersten Hülsenabschnitt (101) und dem zweiten Hülsenabschnitt (103) einen Durchmessersprung aufweist.

8. Hochfrequenzverbindungsadapter (200) nach einem der vorangehenden Ansprüche, wobei ein Ende (401) des Leiterhohlraums (215) des zweiten Innenleiters (211) kegelstumpfförmig, kegelförmig oder kuppelförmig gebildet ist.

9. Hochfrequenzverbindungsadapter (200) nach einem der vorangehenden Ansprüche, wobei der zweite Innenleiter (211) einen ersten Innenleiterabschnitt (213), in welchem der Leiterhohlraum (215) gebildet ist, mit einem dritten Durchmesser und einen zweiten Innenleiterabschnitt (217) mit einem vierten Durchmesser aufweist, wobei der vierte Durchmesser geringer als der dritte Durchmesser ist.

10. Hochfrequenzverbindungsadapter (200) nach Anspruch 9, wobei der zweite Innenleiter (211) an einem Übergang zwischen dem ersten Innenleiterabschnitt (213) und dem zweiten Innenleiterabschnitt (217) einen Durchmessersprung aufweist.

11. Hochfrequenzverbindungsadapter (200) nach einem der vorangehenden, wobei das Adaptergehäuse (223) einen elektrisch leitenden Anteil aufweist, wobei das Gehäuse (207) des ersten Hochfrequenzverbinders (201) und das weitere Gehäuse (219) des zweiten Hochfrequenzverbinders (203) über den elektrisch leitenden Anteil des Adaptergehäuses (223) elektrisch leitend verbunden sind.

12. Hochfrequenzverbindungsadapter (200) nach Anspruch 11, wobei das Adaptergehäuse (223) ferner einen Anschluss (503) zum Anschließen einer Masseleitung (505) aufweist.

13. Hochfrequenzverbindungsadapter (200) nach einem der vorangehendenden Ansprüche, wobei das Gehäuse (207) des ersten Hochfrequenzverbinders (201) oder das weitere Gehäuse (219) des zweiten Hochfrequenzverbinders (203) mit dem Adaptergehäuse (223) verpressbar ist.

## Claims

1. A high frequency connection adapter (200), comprising a dielectric coupling sleeve (100) for the capacitive coupling of a first electrical conductor to a second electrical conductor, wherein the second electrical conductor has a conductor cavity (215), comprising:
a first sleeve section (101) having a first diameter, wherein a receiving space (105) closed on one side is formed in the first sleeve section (101) into which the first electrical conductor is insertable; and
a second sleeve section (103) having a second diameter, wherein the second diameter is smaller than the first diameter, and wherein the second sleeve section (103) is insertable into the conductor cavity (215), wherein the receiving space (105) closed on one side extends at least partly into the second sleeve section (103),
a first high frequency connector (201) comprising a housing (207) and a first inner conductor (205) arranged in a receiving section (209) of the housing (207), wherein the first inner conductor (205) is inserted into the receiving space (105) closed on one side of the first sleeve section (101) and wherein the first sleeve section (101) fills at least a portion of the receiving section (209);
a second high frequency connector (203) having a second inner conductor (211), wherein the second inner conductor (211) comprises a conductor cavity (215), into which the second sleeve section (103) is inserted,
wherein the second inner conductor (211) has a first inner conductor section (213) comprising the conductor cavity (215) and a second inner conductor section (217), and a further housing (219) and an isolating element (221), which galvanically isolates the second inner conductor section (217) and the further housing (219), wherein the second sleeve section (103) of the dielectric coupling sleeve (100) is inserted into the conductor cavity (215), wherein the high frequency connection adapter (200) further comprises an adapter housing (223) and an empty space (225), wherein the further housing (219) is pressed into the adapter housing (223).

2. The high frequency connection adapter (200) according to claim 1, wherein one end (107) of the second sleeve section (105) is dielectrically closed.

3. The high frequency connection adapter (200) according to one of the preceding claims, wherein one end (107) of the second sleeve section (103) is formed in frustoconical, conical or domed shape.

4. The high frequency connection adapter (200) according to one of the preceding claims, wherein the first electrical conductor is retainable in the receiving space (105) closed on one side by frictional connection, and wherein the second sleeve section (103) is retainable in the conductor cavity (215) by frictional connection.

5. The high frequency connection adapter (200) according to one of the preceding claims, wherein the dielectric coupling sleeve (100) is formed as one piece.

6. The high frequency connection adapter (200) according to one of the preceding claims, wherein the dielectric coupling sleeve (100) is formed from polytetrafluoroethylene, polyethylene, polyamide or ceramic.

7. The high frequency connection adapter (200) according to one of the preceding claims, wherein the dielectric coupling sleeve (100) has a jump in diameter at a transition between the first sleeve section (101) and the second sleeve section (103).

8. The high frequency connection adapter (200) according to one of the preceding claims, wherein one end (401) of the conductor cavity (215) of the second inner conductor (211) is formed in frustoconical, conical or domed shape.

9. The high frequency connection adapter (200) according to one of the preceding claims, wherein the second inner conductor (211) comprises a first inner conductor section (213), in which the conductor cavity (215) is formed, having a third diameter and a second inner conductor section (217) having a fourth diameter, wherein the fourth diameter is smaller than the third diameter.

10. The high frequency connection adapter (200) according to claim 9, wherein the second inner conductor (211) has a jump in diameter at a transition between the first inner conductor section (213) and the second inner conductor section (217).

11. The high frequency connection adapter (200) according to one of the preceding, wherein the adapter housing (223) has an electroconductive portion, wherein the housing (207) of the first high frequency connector (201) and the further housing (219) of the second high frequency connector (203) are electroconductively connected by the electroconductive portion of the adapter housing (223).

12. The high frequency connection adapter (200) according to claim 11, wherein the adapter housing (223) further comprises a connection (503) for connecting a ground wire (505).

13. The high frequency connection adapter (200) according to one of the preceding claims, wherein the housing (207) of the first high frequency connector (201) or the further housing (219) of the second high frequency connector (203) is press-fitable to the adapter housing (223).

## Revendications

1. Adaptateur de liaison radiofréquence (200) comprenant un manchon de couplage diélectrique (100) pour coupler de manière capacitive un premier conducteur électrique à un second conducteur électrique, le second conducteur électrique ayant une cavité conductrice (215), comprenant:
une première section de manchon (101) avec un premier diamètre, dans laquelle un espace de réception (105) qui est fermé sur un côté et dans lequel le premier conducteur électrique peut être inséré est formé dans la première section de manchon (101); et
une deuxième section de manchon (103) avec un deuxième diamètre, le deuxième diamètre étant inférieur au premier diamètre, et la deuxième section de manchon (103) pouvant être insérée dans la cavité conductrice (215), l'espace de réception (105) étant fermé d'un côté s'étendant au moins partiellement dans la deuxième section de manchon (103),
un premier connecteur haute fréquence (201) avec un boîtier (207) et un premier conducteur interne (205), qui est agencé dans une section de réception (209) du boîtier (207), le premier conducteur interne (205) étant placé dans l'espace de réception (105) qui est fermé sur un côté de la première section de manchon (101) est inséré et dans lequel la première section de manchon (101) remplit la section de réception (209) au moins par sections;
un second connecteur haute fréquence (203) avec un second conducteur interne (211), le second conducteur interne (211) ayant une cavité conductrice (215) dans laquelle la seconde section de manchon (103) est insérée,
dans lequel le second conducteur interne (211) a une première section de conducteur interne (213) avec la cavité de conducteur (215) et une seconde section de conducteur interne (217), ainsi qu'un autre boîtier (219) et un élément isolant (221) qui a la deuxième section de conducteur interne (217) et isole galvaniquement l'autre boîtier (219), la deuxième partie de manchon (103) du manchon de couplage diélectrique (100) étant enfichée dans la cavité de conducteur (215), l'adaptateur de connexion radiofréquence (200) comprenant en outre un logement d'adaptateur (223) et un vide (225) comprend, dans lequel l'autre logement (219) est pressé dans le logement d'adaptateur (223).

2. Adaptateur de liaison radiofréquence (200) selon la revendication 1, dans lequel une extrémité (107) de la seconde partie de manchon (105) est diélectriquement fermée.

3. Adaptateur de liaison radiofréquence (200) selon l'une des revendications précédentes, dans lequel une extrémité (107) de la seconde partie de manchon (103) est tronconique, conique ou en forme de dôme.

4. Adaptateur de liaison radiofréquence (200) selon l'une des revendications précédentes, dans lequel le premier conducteur électrique peut être maintenu dans l'espace de réception (105) fermé d'un côté par engagement par friction, et la deuxième section de manchon (103) peut être maintenu dans la cavité conductrice (215) par engagement par friction.

5. Adaptateur de liaison radiofréquence (200) selon l'une des revendications précédentes, dans lequel le manchon diélectrique de couplage (100) est formé d'une seule pièce.

6. Adaptateur de liaison radiofréquence (200) selon l'une des revendications précédentes, dans lequel le manchon de couplage diélectrique (100) est formé de polytétrafluoroéthylène, de polyéthylène, de polyamide ou de céramique.

7. Adaptateur de liaison radiofréquence (200) selon l'une des revendications précédentes, dans lequel le manchon diélectrique (100) à une transition entre la première portion de manchon (101) et la deuxième portion de manchon (103) présente un saut de diamètre.

8. Adaptateur de liaison radiofréquence (200) selon l'une des revendications précédentes, dans lequel une extrémité (401) de la cavité conductrice (215) du second conducteur interne (211) est tronconique, conique ou en forme de dôme.

9. Adaptateur de liaison radiofréquence (200) selon l'une des revendications précédentes, dans lequel le deuxième conducteur interne (211) a une première partie de conducteur interne (213), dans laquelle la cavité de conducteur (215) est formée, ayant un troisième diamètre et un deuxième conducteur interne une partie conductrice (217) ayant un quatrième diamètre, le quatrième diamètre étant inférieur au troisième diamètre.

10. Adaptateur de liaison radiofréquence (200) selon la revendication 9, dans lequel le second conducteur interne (211) présente un saut de diamètre au niveau d'une transition entre le premier tronçon de conducteur interne (213) et le second tronçon de conducteur interne (217).

11. Adaptateur de liaison radiofréquence (200) selon l'une des précédentes, dans lequel le boîtier d'adaptateur (223) a une partie électriquement conductrice, le boîtier (207) du premier connecteur haute fréquence (201) et l'autre boîtier (219) du second connecteur haute fréquence (203) via sont électriquement connectés à la partie électriquement conductrice du boîtier d'adaptateur (223).

12. Adaptateur de liaison radiofréquence (200) selon la revendication 11, dans lequel le boîtier d'adaptateur (223) comprend en outre une borne (503) pour connecter une ligne de masse (505).

13. Adaptateur de liaison radiofréquence (200) selon l'une des revendications précédentes, dans lequel le boîtier (207) du premier connecteur haute fréquence (201) ou l'autre boîtier (219) du deuxième connecteur haute fréquence (203) peut être pressé avec le boîtier adaptateur (223).
